## Europäisches Patentamt
## European Patent Office
## Office européen des brevets

(19)

(11) Veröffentlichungsnummer : **0 404 766 B1**

(12)

# EUROPÄISCHE PATENTSCHRIFT

(45) Veröffentlichungstag der Patentschrift :
**08.04.92 Patentblatt 92/15**

(21) Anmeldenummer : **88904487.1**

(22) Anmeldetag : **01.06.88**

(86) Internationale Anmeldenummer :
**PCT/DE88/00319**

(87) Internationale Veröffentlichungsnummer :
**WO 89/08893 21.09.89 Gazette 89/23**

(51) Int. Cl.⁵ : **G06K 15/12,** H05K 7/20,
H01L 25/04, H01L 27/15,
H01L 23/40, F16B 5/02,
B41J 2/435

(54) ANORDUNG ZUM LÖSBAREN BEFESTIGEN VON MODULEN AUF EINEM MODULTRÄGER.

(30) Priorität : **15.03.88 DE 3808619**

(43) Veröffentlichungstag der Anmeldung :
**02.01.91 Patentblatt 91/01**

(45) Bekanntmachung des Hinweises auf die
Patenterteilung :
**08.04.92 Patentblatt 92/15**

(84) Benannte Vertragsstaaten :
**DE FR GB IT NL SE**

(56) Entgegenhaltungen :
**EP-A- 0 232 098**
**DE-U- 8 704 510**
**IBM Technical Disclosure Bulletin, Vol. 22, No.
3, August 1979, (New York, US), F. J. DeMaine
et al.: "Attachable heat sink for pluggable
modules", pages 960-961 see figs.**

(73) Patentinhaber : **Siemens Nixdorf
Informationssysteme AG
Otto-Hahn-Ring 6
W-8000 München 83 (DE)**

(72) Erfinder : **SCHREYER, Siegfried
Furtmüllerweg 11
W-8011 Glonn (DE)**
Erfinder : **WÄCHTLER, Rudolf
Oberländerstrasse 22
W-8000 München 70 (DE)**
Erfinder : **CREUTZMANN, Edmund
Josef-Retzer-Strasse 19
W-8000 München 60 (DE)**

(74) Vertreter : **Fuchs, Franz-Josef, Dr.-Ing.
Postfach 22 13 17
W-8000 München 22 (DE)**

**Beschreibung**

Die Erfindung betrifft eine Anordnung zum lösbaren Befestigen von Module auf einem Modulträger gemäß dem Oberbegriff des Patentanspruches 1.

Aus dem IBM Technical Disclosure Bulletin; Vol. 22, No. 3; Aug. 1979 "Attachable Heat Sink for pluggable Moduls" ist es bekannt, Module mittels eines Schrumpfringes oder einer Schrumpfmanschette auf einer Wärmesenke zu befestigen.

In der EP-A-0 232 098 ist eine Wärmesenke (Kühlblech) für elektronische Bauteile beschrieben, bei der die elektronischen Bauteile über eine Spindel oder ein Rohr in eine Durchtrittsöffnung der Wärmesenke eingelassen ist. Auf der Spindel bzw. dem Rohr ist ein abnehmbarer Deckel befestigt, auf dem das elektronische Bauteil mit einem gut wärmeleitenden Material aufgeklebt wird. Zwischen dem elektronischen Bauteil, das auf einer Platine angeordnet ist, und dem Kühlblech besteht nur eine mittelbare wärmeleitende Verbindung. Die Wärmeleitung wird ausschließlich durch die Spindel bzw. das Rohr mit dem dazugehörigen Deckel bewerkstelligt.

Aus dem DE-U-87 04 510 ist eine Anordnung zum lösbaren Befestigen von Module an einem Modulträger bekannt, bei der LED-Submodule, die aus einer wärmeleitenden Keramikplatte angefertigt sind, auf einer Wärmesenke aufgeklebt sind. Zur elektronischen Ansteuerung der LED's auf der Keramikplatte sind zwei Leiterplatten vorgesehen, die jeweils eine Vielzahl von elektronischen Bauteilen aufweisen. Die Leiterplatten sind darüber hinaus an den Seitenflächen der Wärmesenke verschraubt.

Die Modulbauweise ist eine in der Technik verbreitete Methode, mechanische aber auch nichtmechanische Systeme aufzubauen. Gegenüber der Kompaktbauweise ist der modulare Aufbau in einem wesentlichen Punkt als vorteilhafter anzusehen. Dies ist dann der Fall, wenn das aufzubauende System Systemelemente enthält, die unter dem Begriff der Verschleißteile einzuordnen sind und daher entsprechend häufig ausgewechselt werden müssen. Das Auswechseln lediglich einzelner Verschleißteile gegenüber dem Auswechseln des ganzen Systems hat zur Folge, daß die Kompaktbauweise, trotz geringer Fertigungskosten, letztlich doch unwirtschaftlicher ist als der modulare Aufbau des Systems.

Stellvertretend für die große Anwendungspalette derartiger Systeme ist im folgenden ein typisches Beispiel aus der nichtmechanischen Druckertechnologie angeführt. Das Kernstück solcher beispielsweise nach dem Prinzip der Elektrofotografie arbeitende Druckeinrichtungen sind optische Zeichengeneratoren. Die Aufgabe dieser optischen Zeichengeneratoren ist es, die in Form von elektronischen Daten vorliegende Druckinformation in ein optisches Bild umzusetzen. Mit diesem optischen Bild wird daran anschließend eine fotoleitende Schicht, z.B. eine Fotoleitertrommel, belichtet. Danach wird das belichtete Bild in bekannter Weise entwickelt und z.B. auf Papier umgedruckt.

Darüber hinaus sind solche optische Zeichengeneratoren von Vorteil, die zeilenartig aufgebaut sind und deshalb ohne mechanische Bewegung arbeiten. Bei dieser Art der Zeichengenerierung muß für jeden Punkt, der innerhalb einer Zeile abgebildet werden soll, eine separate Lichtquelle vorhanden sein. Die Anzahl dieser Lichtquellen innerhalb einer Belichtungszeile von optischen Zeichengeneratoren hängt weitestgehend davon ab, mit was für einen Druckraster die zu druckende Information umgesetzt wird. Als Lichtquellen in den optischen Zeichengeneratoren werden vorzugsweise lichtemittierende Dioden (LED's) eingesetzt. Diese haben wie alle anderen Lichtquellen die nachteilige Eigenschaft, daß die Lebensdauer begrenzt ist. Für den optischen Zeichengererator gilt es daher, diesem unvermeidbaren Tatbestand durch eine erhöhte Wartungsfreundlichkeit entgegenzuwirken, indem die Belichtungszeile des Zeichengenerators modulartig aufgebaut wird. Gegenüber der Kompaktbauweise weist der Modulaufbau häufig jedoch den Nachteil auf, daß jedes einzelne Modul auf einen Modulträger durch einen kostspieligen mechanischen Aufwand separat befestigt werden muß. Für den optischen Zeichengenerator wirkt es sich darüber hinaus noch nachteilig aus, daß der Aufbau des optischen Zeichengenerators die Art und Weise der Befestigung maßgeblich beeinflußt.

Der vorliegenden Erfindung liegt daher die Aufgabe zugrunde, eine Anordnung der eingangs genannten Art zu schaffen, mit dem Module auf Modulträgern und insbesondere Belichtungsmodule eines optischen Zeichengenerators, bei dem zudem sowohl die Module als auch der Modulträger thermisch beansprucht sind und demzufolge Wärmedehnungen auftreten, in einer gesicherten bzw. reproduzierbaren Position lösbar befestigt und die Kosten für die Befestigung auf ein Minimum begrenzt werden.

Diese Aufgabe wird erfindungsgemäß bei einer Anordnung der eingangs genannten Art durch die im Kennzeichen des Hauptanspruches beschriebenen Merkmale gelöst.

Die Lösung zeichnet sich insbesondere dadurch aus, daß eine Schraub/Federverbindung die Module auf dem Modulträger befestigt. Darüber hinaus ist die Schraub/Federverbindung in einer Bohrung des Modulträgers bzw. des Moduls äußerst montagefreundlich angeordnet. Die Schraub/Federverbindung gewährleistet insbesondere im Zusammenhang mit der sehr genau mechanisch bearbeiteten Berührungsfläche des Modulträgers und des Moduls eine formschlüssige Anlage des Moduls senkrecht und parallel zur Berührungsfläche des Modulträgers. Diese formschlüssige Anlage bleibt auch bei äußeren Einwirkungen beispielsweise bei auftretenden Wärmedehnungen erhalten. Bei der Lösung ist es außerdem vorteilhaft, daß durch die hochgenaue formschlüssige Anlage des Moduls auf dem Modulträger ein guter Wärmeübergang mit einem kleinen Wärmewiderstand gegeben ist. Dieser Sachverhalt ist dann von Bedeutung, wenn sowohl das Modul als auch der Modulträger thermisch beansprucht wird. Dieses ist beispielsweise bei den optischen Zeichengeneratoren gegeben, wo auf jedem Modul innerhalb einer Belichtungszeile Lichtquellen angeordnet sind, die eine thermische Verlustleistung abgeben.

Weitere Vorteile und Weiterbildungen der Erfindung ergeben sich aus den Unteransprüchen sowie aus der nachfolgenden Beschreibung eines Ausführungsbeispieles anhand der Zeichnunger. Dabei zeigen:

FIG 1 einen im Querschnitt dargestellten, prinzipiellen Teilaufbau eines elektrofotografischen Druckers zum Erzeugen eines latenten, elektrostatischen Bildes,

FIG 2 in einer perspektivisch-axonometrischen Darstellung den Aufbau eines latente Bilder erzeugenden Zeichengenerators,

FIG 3 die Draufsicht auf ein Befestigungselement für die Fixierung des Zeichengenerators,

FIG 4 die Draufsicht auf ein für Erzeugung latenter, elektrostatischer Bilder erforderliches Belichtungsmodul des Zeichengenerators,

FIG 5 die Anordnung der zu einer Belichtungszeile des Zeichengenerators zusammengefaßten lichtemittierenden Dioden (LED's),

FIG 6 einen Querschnitt durch den Zeichengenerator mit einer ersten Ausführungsform zum Befestigen der Belichtungsmodule,

FIG 7 einen Querschnitt durch den Zeichengenerator mit einer zweiten Ausfühiungsform zum Befestigen der Belichtungsmodule,

FIG 8 einen Querschnitt durch den Zeichengenerator mit einer dritten Ausführungsform zum Befestigen der Belichtungsmodule,

FIG 9 einen Schnitt durch den Zeichengenerator.

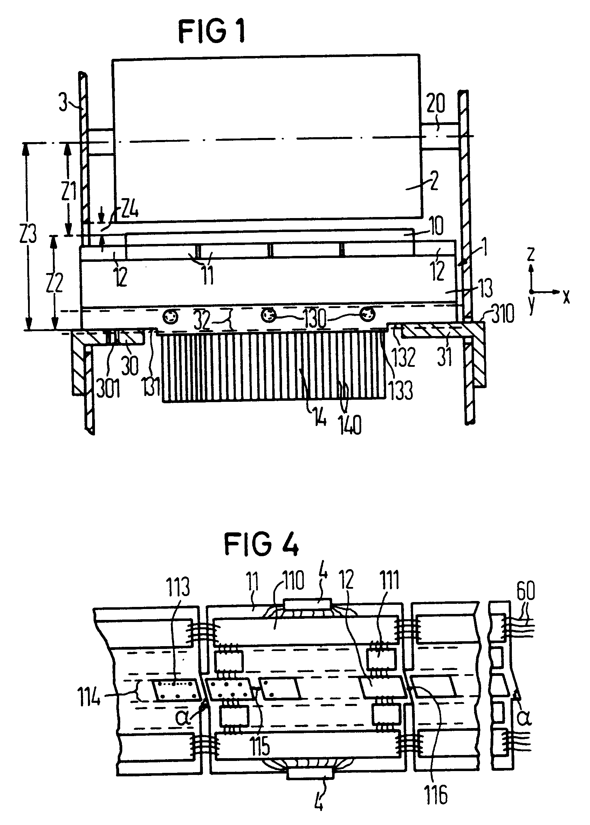

Die FIG 1 zeigt, wie ein Zeichengenerator 1 und eine Umdrucktrommel 2 in einem Druckergehäuse 3 eines Druckers eingebaut sind. Die Umdrucktrommel 2 ist dazu auf einer im Druckergehäuse 3 rotierbar gelagerten Spindel 20 axial festgelegt. Unterhalb der drehbar gelagerten Umdrucktrommel 2 ist in einem veränderbaren Abstand z3 der Zeichengenerator 1 in dem Druckergehäuse 3 befestigt. Der Zeichengenerator 1 ist dazu an seinen beiden Enden auf justierbaren Befestigungselementen 30, 31 fest montiert. Die im Querschnitt winkelförmigen Befestigungselemente 30, 31 sind in das Druckergehäuse 3 derart integriert, daß die Lage der Befestigungsebenen 300 bzw. 310 der Befestigungselemente 30, 31 bezogen auf die Rotationsachse der Umdrucktrommel 2 mit einer Lehre auf den Abstand z3 justiert werden kann. Der so eingestellte Abstand z3 setzt sich dabei aus zwei verschiedenen Einzelabmaßen z1, z2 zusammen. Für einen einwandfreien Betrieb des Druckers ist es unablässig, daß eine vorgegebene und auch einzuhaltende Gesamttoleranz für den eingestellten abstand z3 durch auftretende Fertigungs- und Montagetoleranzen für die beiden Abmaße z1, z2 nicht überschritten wird.

Bestimmt wird die Gesamttoleranz im wesentlichen durch eine Abbildungsoptik 10 des Zeichengenerators 1. So darf die Tiefenschärfe der Abbildungsoptik 10 durch die angesprochenen Toleranzen im Interesse einer guten Abbildungsqualität nicht verändert werden. Dies erklärt sich aus der Tatsache, daß durch die Abbildungsoptik 10 Bildpunkte von Lichtquellen beispielsweise lichtemittierenden Dioder. (LED's) auf die Umdrucktrommel 2 reproduziert werden. Angeordnet sind diese Lichtquellen jeweils auf einem Belichtungsmodul 11, das mit dem Steg eines T-förmig ausgebildeten Modulträgers 13 formschlüssig verbunden ist. Auf dem Steg des Modulträgers 13 sind weiterhin Anschlagelemente 12 vorgesehen, die ein Verschieben der Belichtungsmodule 11 im Betriebszustand des Zeichengenerators 1 in X-Richtung verhindern. Der Flansch des T-förmig ausgebildeten Modulträgers 13 weist zudem Laufrollen 130 auf, die jeweils paarweise an den beiden langen Stirnflächenseiten des Flansches diametral zueinander befestiat sind. Darüber hinaus gliedert sich die Gründfläche des Flansches in zwei Auflageflächen 131, 132 sowie einer von diesen beiden Auflageflächen 131, 132 abgesetzten Stufenfläche 133 auf, auf der mehrere einen Kühlkörper 14 bildende Kühlbleche 140 befestigt beispielsweise angelötet sind.

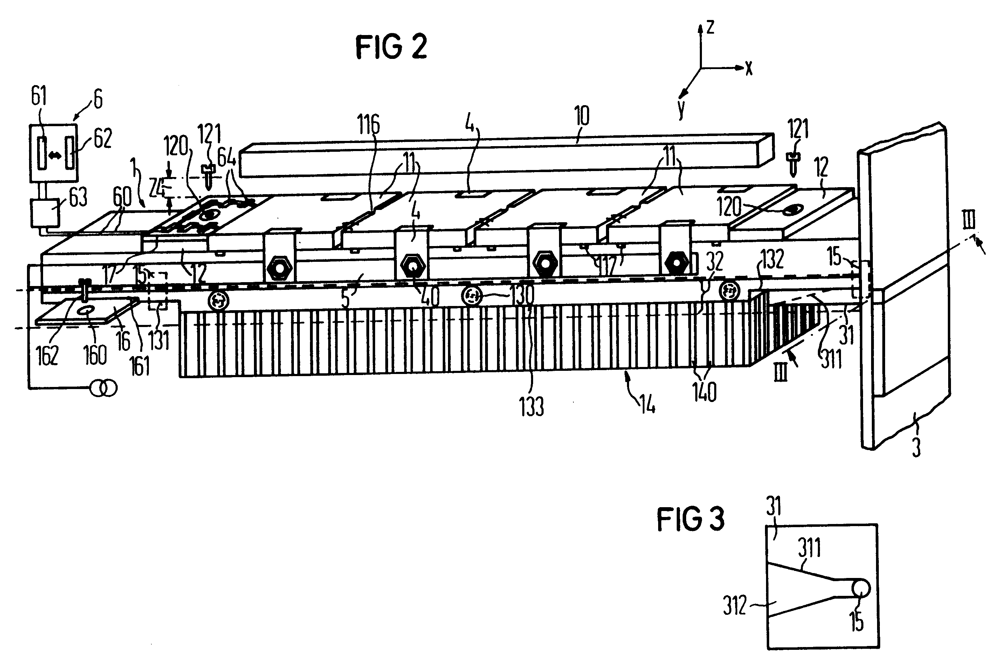

Für den Betrieb des Druckers wird der Zeichengenerator dadurch, daß die Laufrollen 130 in Führungsschienen 32 des Druckergehäuses 3 in X-Richtung bewegbar sind, so weit in das Druckergehäuse 3 eingeschoben, bis der Zeichengenerator 1 in den Befestigungsebenen 300, 301 mit seinen Auflageflächen 131, 132 auf den Befestigungselementen 30, 31 aufliegt. Der so eingebaute Zeichengenerator 1 bildet mit der Umdrucktrommel 2 bezüglich der in FIG 1 eingezeichneten Abmaße z1 bis z3 eine konstruktive Einheit, die sich lediglich bei ständig wechselnden, unterschiedlichen Fertigungs- und Montagetoleranzen wieder ändert. So ergeben sich zum Beispiel in bezug auf ein Abmaß z4, das den tangentialen Abstand zwischen der Umdrucktrommel 2 und der Abbildungsoptik 10 angibt, Fertigungstoleranzen, denen ein verändernder Spindelschlag der Umdrucktrommel 2 zugrundeliegt. Ist beispielsweise für eine zu fordernde Gesamttoleranz des Abstandes z3 dz3 = 0,1 μm und wird in Folge des Spindelschlages für das Abmaß z4 eine Toleranz von ebenfalls 0,1 μm bei gleichzeitig hochgenauer Fertigung der Umdrucktrommel 2 berücksichtigt, so muß der Zeichengenerator 1 mit einer Genauigkeit von mindestens 0,01 μm gefertigt werden, um ein einwandfreies Abbilden der Bildpunkte von den Lichtquellen auf die Umdrucktrommel 2 zu gewährleisten. Hieraus ergeben sich sehr hohe Anforderungen an die konstruktive Gestaltung des Zeichengenerators 1, auf die im folgenden bei der Beschreibung der FIG 2 bis 9 eingegangen wird.

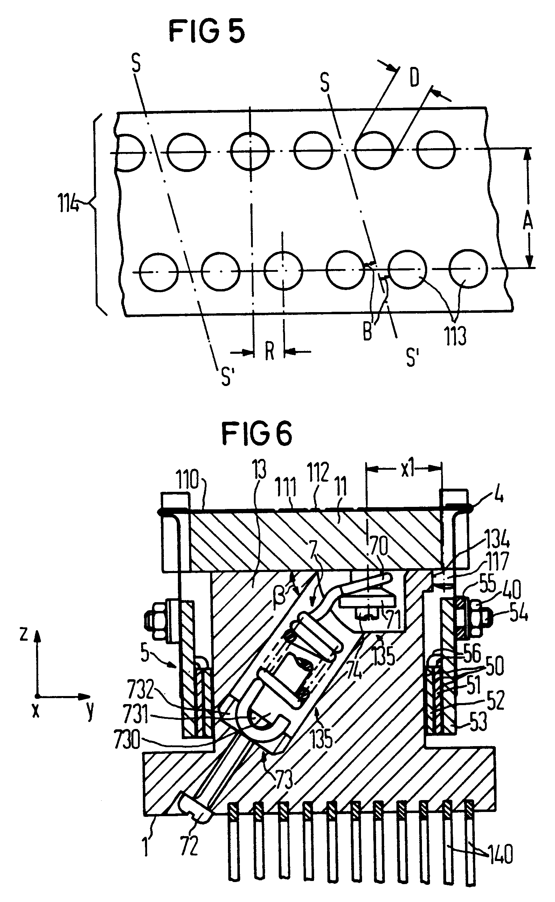

Die FIG 2 zeigt dazu in einer perspektivisch-axonometrischen Darstellung den prinzipiellen Aufbau des Zeichengenerators 1. Auf dem Steg des Modulträgers 13 sind in Längsrichtung die vier in FIG 1 angedeuteten Belichtungsmodule 11 form- und kraftschlüssig angeordnet. Hierfür werden beide Berührungsflächen sowohl die des Modulträgers 13 als auch die der Belichtungsmodule 11 in einem speziellen Fertigungsgang auf eine sehr hohe Genauigkeit mechanisch bearbeitet, um im Montagezustand zwischen den beiden Berührungsflächen einen Luftspalt kleiner als 2 μm zu erzielen. Die so angeordneten Belichtungsmodule 11 stoßen untereinander jeweils an mit höchster Präzision gefertigten Fügeflächen 116 zusammen. So ist der Luftspalt zwischen den Fügeflächen 116 ebenfalls kleiner als 2 μm. Das Zusammenstoßen der Module 11 findet jedoch nur in einem sehr schmalen Bereich statt. Die Gründe hierfür werden bei der Beschreibung der FIG 3 näher erläutert. Damit dieses deckungsgleiche Aneinanderliegen der jeweiligen Module 11 auch während des Betriebszustandes erhalten bleibt, wird für alle drei Koordinatenrichtungen die Lagre der Belichtungsmodule 11 auf dem Modulträger 13 fixiert. Für die X-Richtung ist dazu bereits bei der Beschreibung der FIG 1 auf die Anschlagelemente 12 hingewiesen worden. In diesen Anschlagelementen 12 ist jeweils eine Bohrung 120 eingelassen, um die Anschlagelemente 12 beispielsweise mit Hilfe von Befestigungsschrauben 121 an einer vorgegebenen Stelle auf dem Steg des Modulträgers 13 zu befestigen. Der Abstand der Bohrungen 120 ist im Montagezustand der Anschlagelemente 12 so bemessen, daß die zwischen den Anschlagelementen 12 liegenden Module 11 in X-Richtung formschlüssig verspannt sind. Das formschlüssige Fixieren der Module 11 in Y- und Z-Richtung wird bei der Beschreibung der FIG 5, 6, 7 näher erläutert. Auf dem einen Anschlagelement 12 liegt darüber hinaus noch eine gedruckte Leiterplatte 15 auf, die gleichfalls mit der Befestigungsschraube 121 festgelegt wird.

Die FIG 2 zeigt außerdem, daß die Abbildungsoptik 10 in einem Abstand z4' über der Moduloberfläche angeordnet ist und daß die Belichtungsmodule 11 an deren jeweils noch frei zugänglichen Stirnflächen 117 eine flexible elektrische Flachbandleitung 4 aufweisen, über die sie mit Strom für die lichtemittierenden Dioden und Ansteuerungselektroniken versorgt werden. Dazu ist jede flexible Flachbandleitung 4 über eine Schraubverbindung 40 mit einem flächenförmigen elektrischen Zuleitungsstrang 5 verbunden, der sich in X-Richtung vorbei an allen auf dem Modulträger 13 angeordneten Belichtungsmodulen 11, auf beiden Längsseiten des Modulträgersteges erstreckt. Die Notwendigkeit eines solchen großflächig ausgestalteten Zuleitungsstranges 5 erklärt sich aus der Tatsache, daß aufgrund der großen Anzahl der auf den Modulen 11 des Zeichengenerators 1 integrierten lichtemittierenden Dioden Ströme von 80 bis 100 A nicht ungewöhnlich sind. Die Ansteuerung der lichtemittierenden Dioden wird über Daten- und Steuerleitungen 60 von einer mikroprozessorgesteuerten Einrichtung 6 vorgenommen, die hierfür unter anderem einen Zentralprozessor 61 und einen Speicher 62 enthält. Dieser mikroprozessorgesteuerten Einrichtung 6 nachgeschaltet sind ein Analog/Digitalwandler 63 sowie mehrere verstärkende Treiberbausteine 64, die auf der gedruckten Leiterplatte 17 angeordnet sind. Von den Treiberbausteinen 64 werden die Signale auf den Daten- und Steuerleitungen verstärkt an die lichtemittierenden Dioden weitergeleitet.

Der Zeichengenerator 1 weist außerdem unter der Auflagefläche 131 ein plattenförmig ausgestaltetes Feststellelement 16 und unter den Auflageflächen 131, 132 einen jeweils aus dem Modulträger 13 herausragenden Führungsbolzen 15 auf. Wird der Zeichengenerator 1 nun zum Einbau in das Druckergehäuse 3 mit seinen Führungsrollen 130 entlang der Führungsschiene 32 eingeschoben, so wird dabei der jeweils unterhalb der Auflageflächen 131, 132 mittig herausragende Führungsbolzen 15 entlang einer Rampe 311 des Befestigungselementes 31 bis in den in FIG 3 dargestellten Anschlag eines sich zum Anschlag hin verjüngenden Führungsschlitzes 312 gebracht. Die Verjüngung des Führungsschlitzes 312 ist so bemessen, daß der Führungsbolzen 15 in Y-Richtung spielfrei fixiert ist. Die Lagefixierung des Zeichengenerator 1 in X-Richtung wird durch das plattenförmige Feststellelement 16 bewirkt. Das Feststellelement 16 wird dazu in einer Ausnehmung 161 der Auflagefläche 131, mit der es eine bündige Oberfläche bildet, derart befestigt, daß jeweils ein gleichgroßes Teil des Feststellelementes 16 auf den beiden Längsseiten des Zeichengenerators 1 herausragt. In diesem herausragenden Teil ist jeweils in der Mitte eine Bohrung 160 eingelassen. Liegt der Zeichengenerator 1 mit seiner Auflagefläche 132 in der Berührungsebene 310 auf dem Befestigungselement 31 auf und liegt der Zeichengenerator 1 gleichfalls mit seiner Auflagefläche 131 in der Berührungsebene 300 auf dem Befestigungselement 30 auf, so wird dieser durch zwei Befestigungsschrauben 162, die in einer entsprechenden Gewindebohrung 301 gemäß der Darstellung in FIG 1 eingelassen sind, in X-Richtung fixiert. Der Zeichenge-

EP 0 404 766 B1

nerator 1 bzw. der Modulträger 13 ist somit gegenüber der in FIG 1 dargestellten Umdrucktrommel 2 in allen drei Koordinatenrichtungen eindeutig festgelegt.

Um im folgenden mit dem so positionierten Zeichengenerator 1 latente, elektrostatische Bilder auf der Umdrucktrommel 2 zu erzeugen und dadurch letztlich auf einem Aufzeichnungsträger beliebige Zeichen drucken zu können, sind auf den Belichtungsmodulen 11, wie die FIG 4 zeigt, in einer Belichtungszeile 114 in einem regelmäßigen Abstand die lichtemittierender Lichtquellen 113 als Chips 112 mit paarweise parallelen Seiten und je nach Druckraster mit 64 oder 128 enthaltenen LED's monolithisch integriert. Stellvertretend hierfür sind in FIG 4 Punkte als LED's eingezeichnet. Darüber hinaus sind in der FIG 5 die LED's vergrößert als konzentrische Kreise mit dem Durchmesser D dargestellt. Gemäß der FIG 5 sind die einzelnen LED's in der Belichtungszeile 114 bzw. auf den Chips 112 in zwei in einem äquidistanten Abstand A verlaufenden Reihen jeweils im Abstand A um einen Versatz R angeordnet. Bestimmt wird dieser Versatz in Abhängigkeit vom Druckraster. Typische verwendete Druckraster sind z. B. 240 dpi (dots per inch), 300 dpi und 600 dpi. Das Versetzen der LED's 117 ist unter anderem deshalb erforderlich, weil der Durchmesser D der LED's 113 für die genannten Druckraster größer ist als der daraus resultierende Versatz R und deshalb die LED's 113 nicht in einer einreihigen, durchgehenden Belichtungszeile 114 angeordnet werden können. Im übrigen ist die Zahl 64 bzw. 128 für die Anzahl der LED's 113 pro Chip 112 auf den Modulen 11 des Zeichengenerators 1 nicht willkürlich gewählt, sondern orientiert sich an Gegebenheiten, die mit der digitalen Ansteuerung der LED's 113 zusammenhängen. Für diese digitale Ansteuerung ist für jede LED-Reihe des Chips 112 auf dem Modul 11, wie in FIG 4 zu sehen, ein integrierter Schaltkreis 111 vorgesehen. Jeder dieser integrierten Schaltkreise 111 ist über ein Bussystem 110 sowohl mit der flexiblen Flachbandleitung 4 als auch über die Treiberbausteine 64 auf der gedruckten Leiterplatten 17 mit den Daten und Steuerleitungen 60 verbunden und damit an die Stromversorgung bzw. die mikroprozessorgesteuerte Einrichtung 6 angeschlossen. In dieser Einrichtung 6 werden sämtliche Druckdaten von den lichtemittierenden Dioden 113 in der Belichtungszeile 114 gespeichert und aufbereitet. Die Anzahl dieser Druckdaten hängt dabei im wesentlichen von dem Abstand A zwischen den beiden LED-Reihen ab. Je kleiner dieser Abstand A ist, desto einfacher können die Druckdaten in der mikroprozessorgesteuerten Einrichtung 6 aufbereitet werden. Diese aufgrund der Elektronik an den Abstand A gestellte Forderung läßt sich jedoch dann nicht mehr einhalten, wenn die in FIG 5 ausgebildete Belichtungszeile 114 gemäß der Darstellung in FIG 4 in einzelne Chips 112 unterteilt werden soll und dabei ein Abstand B zwischen einer Trennungslinie S...S' und den dazu benachbarten LED's 113 möglichst groß sein soll, um diese nicht zu beschädigen. Der größtmögliche Abstand B wäre in diesem Fall genau dann gegeben, wenn der Abstand A zwischen den beiden LED-Reihen unendlich groß wäre. Die Lösung dieses Optimierungsproblems ist durch die Gleichung

$$A = 4 R \quad (1)$$

gegeben. Dies ist gleichbedeutend damit, daß die Belichtungszeile 114 in der Mitte zwischen zwei benachbarten LED's 113 auf der LED-Reihe unter einem Winkel von $\alpha = 76°$ durchgetrennt wird. Je nachdem, welches Druckraster für den Zeichengenerator 1 gewählt wird, ergibt sich eine unterschiedliche Anzahl von Chips 112 auf dem einzelnen Modul 11. Hierbei muß es jeden Fall gewährleistet sein, daß die Länge des Moduls 11 in X-Richtung ein ganzzahliges Vielfaches der Länge des einzelnen Chips 112 beträgt. Andererseits ist die Anzahl der Belichtungsmodule 11 für verschiedene Formate von Aufzeichnungsträgern optimiert, wie die nachstehende Tabelle verdeutlicht.

| Druck-raster | LED's pro Chip | Chips pro Belichtungsmodul | Anzahl der Module für eine Gesamtzeile der Breite | |
|---|---|---|---|---|
| | | | DIN A4 quer | DIN A3 quer |
| 240 dpi | 64 | 9 | 5 | 8 |
| 300 dpi | 64 | 14 | 4 | 6 |
| 600 dpi | 128 | 14 | 4 | 6 |

Entsprechend der Moduleinteilung wird der Rohling, aus dem die einzelnen Belichtungsmodule 11 gefertigt werden, unter dem Winkel $\alpha$ im Bereich der Belichtungszeile 114 besonders sorgfältig durchgetrennt und danach noch mit höchster Toleranzgenauigkeit mechanisch bearbeitet. Dieses ist deshalb erforderlich, damit die durch die mechanische Bearbeitung entstehenden Fügeflächen 116 die Homogenität der gesamten Belichtungszeile 114 über alle Belichtungsmodule 11 des Zeichengenerators 1 beim Verspannen der Module 11 in X-Richtung nicht nachteilig beeinflussen. Daß diese Fügeflächen 116 sich nicht nachteilig auf die Homogenität auswirken, ist andererseits erst durch einen genügend großen Fügespalt 115 zwischen den einzelnen Chips

5

112 auf jedem Modul 11 gegeben. Die Größe des Fügespalts 115 ist aber wiederum weitestaehend davon abhängig, wie groß der Abstand B zwischen der Trennlinie S...S' und den benachbarten LED's 113 ist.

Die FIG 6 zeigt einen Querschnitt durch den Zeichengenerator 1, um damit die Fixierung der einzelnen Module 11 auf den Steg des T-förmig ausgebildeten Modulträgers 13 zu verdeutlichen. Die Voraussetzung für eine derartig funktionierende erste Befestigungseinrichtung 7, wie sie in FIG 6 dargestellt ist, sind die mit höchster Präzision mechanisch bearbeiteten Berührungsflächen des Modulträgers 13 und der einzelnen Module 11. Das gleiche gilt in diesem Zusammenhang auch für eine Anlagefläche 134 des Modulträgers 13. An dieser Anlagefläche 134 liegt im montierten Zustand des Belichtungsmoduls 11 ein Anlagestift 117 formschlüssig an. Gemäß der Darstellung in FIG 2 sind für jedes Belichtungsmodul 11 zwei solcher Anlagestifte 117 vorgesehen. Die Anlagestifte 117 sind dazu mit festem Sitz in die jeweiligen Belichtungsmodule 11 eingelassen. Jedes dieser Belichtungsmodule 11 weist darüber hinaus auf der Berührungsfläche zwischen den beiden Anlagestiften 117 in einem Abstand x1 von diesen eine Gewindebohrung auf, in die eine Schraube 74 mit einem den Schraubenschaft umgebenden, sich zum Schraubenkopf hin in radialer Richtung verbreitenden ersten Formteil 71 eingelassen ist. Um dieses Formteil wird eine auf Zugbeanspruchung belastbare Schraubenfeder 70 eingehängt. In diese Schraubenfeder 70 ist ein zweites Formteil 73 eingesetzt. Dieses zweite Formteil 73 weist dazu einen zylindrischen Schaft 730 mit einem Innen- und Außengewinde auf. Das Außengewinde ist dabei in axialer Richtung nur soweit ausgebildet, um eine Sechskantschraubenmutter 732 mit einer durch mechanisches Bearbeiten ausgebildeten segmentartigen Nase 731 auf den zylindrischen Schaft befestigen zu können. Der Einbau dieses Formteils 73 in die Feder 70 erfolgt derart, daß das andere Federende die Nase 731 umgibt. Geführt wird diese Feder 70 in einer zylindrischen Bohrung 135, die beispielsweise unter einem Winkel β von 55° zur Berührungsfläche des Modulträgers 13 von dieser Berührungsfläche den Steg des Modulträgers 13 zunächst bis zum Steg Flanschübergang durchdringt. An dieser Stelle verkleinert sich die Bohrung 135 maximal auf den Durchmesser einer Bewegungsschraube 72 bis zur Grundfläche des Modulträgerflansches. Am jeweiligen Ende der Bohrung ist diese entsprechend der äußeren Abmaße des Schraubenkopfes der Bewegungsschraube 72 bzw. der Abmaße der Schraube 74 und des ersten Formteils 71 großzügig aufgebohrt. Im Montagezustand des Moduls 11, wenn dieses mit seiner Berührungsfläche auf dem Steg des Modulträgers 13 aufliegt, wird das Modul 11 durch die in Z-und Y-Richtung wirkende Federkraft beim Drehen der Bewegungsschraube 72 im Uhrzeigersinn mit dem Steg des Modulträoers 13 fest verspannt und andererseits der Anlagestift 117 des Belichtungsmoduls 11 an die Anlagefläche 134 des Modulträgers 13 gedrückt.

Die FIG 6 zeigt außerdem, wie der flächenförmige elektrische Zuleitungsstrang 5 in Verbindung mit der flexiblen Flachbandleitung 4 aufgebaut ist. Danach ist der Zuleitungsstrang 5 auf beiden Längsseiten des Modulträgerstegs jeweils schichtweise aus drei nicht elektrisch leitfähigen Isolierschienen 50, jeweils zwei gegenüber das Massepotential des Modulträgers 13 potentialmäßig voneinander abweichenden Stromversorgungsschienen 51, 52 und jeweils aus einer zweipoligen Kontaktschiene 53 zusammengesetzt ist, wobei die Kontaktschiene 53 jeweils über zwei Stromzuführungen 56 mit den Stromversorgungsschienen 51, 52 verbunden ist. Darüber hinaus weist die Kontaktschiene 53 einen senkrecht nach außen abstehenden Gewindezapfen 54 auf, auf den nacheinander die flexible Flachbandleitung 4, eine Scheibe 55 aufgeschoben und durch die Schraubverbindung 40 der Kontakt zwischen der Kontaktschiene 53 und dem flexiblen Flachband 4 hergestellt wird. Befestigt wird der flächenförmige elektrische Zuleitungsstrang 5, in dem zunächst in abwechselnder Reihenfolge die nicht elektrisch leitfähigen Isolierschienen 50 und die Stromversorgungsschienen 51, 52 sowie danach die Kontaktschiene 53 an die jeweilige Längsseite des Modulträgerstegs angeklebt werden.

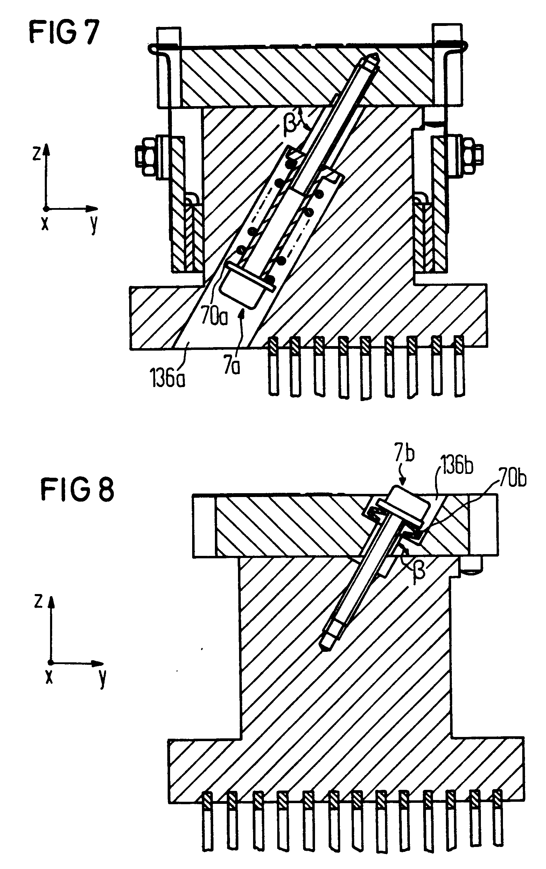

Alternativ zu der soeben beschriebenen Ausführungsform für die Modulbefestigung zeigt die FIG 7 eine Möglichkeit auf, die Belichtungsmodule 11 mit einer zweiten Befestigungseinrichtung 7a direkt zu verschrauben und dabei für die der Verschraubung entgegenwirkende Kraft eine Druckfeder 70a zu verwenden. Zur Führung der zweiten Befestigungseinrichtung 7a ist wieder unter dem Winkel β zur Berührungsfläche des Modulträgerstegs eine Bohrung 135a in diesen eingelassen. Die zweite Befestigungseinrichtung 7a wird zum Fixieren der Belichtungsmodule 11 von der Grundfläche des Flansches aus in die Bohrung 135a eingeführt.

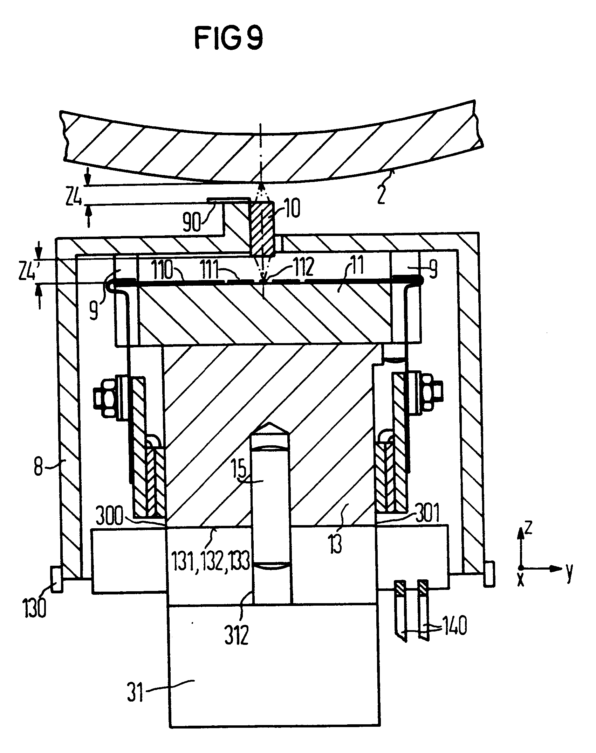

Eine weitere Alternative zum Fixieren der Module 11 auf den Modulträgersteg zeigt die FIG 8 auf. Im Unterschied zu den beiden vorangegangenen Ausführungsformen wird eine dritte Befestigungseinrichtung 7b von der Modulseite in eine Bohrung 136b eingelassen, die im Winkel β zur Berührungsfläche des Belichtungsmoduls 11 geneigt ist. Die der Verspannung entgegenwirkende Federkraft wird durch eine auf Druckbeanspruchungen reagierende Tellerfeder 70b erzeugt. Diese Ausführungsformen der Modulfixierung kann jedoch nur für Belichtungsmodule 11 verwendet werden, bei denen die Integrationsdichte der Chips 112 nahezu um die Hälfte geringer ist. So ist diese Art der Modulbefestigung beispielsweise bei Zeichengeneratoren 1 mit einem Druckraster von 240 dpi möglich.

Die FIG 9 zeigt in einem Schnitt durch den Zeichengenerator 1 wie dieser in dem Druckergehäuse 3 in Y-Richtung fixiert ist. Dazu ist insbesondere dargestellt, wie der Führungsbolzen 15 in den Steg des Modulträgers 13 eingelassen ist. Außerdem ist gezeigt, wie die Abbildungsoptik 10 gegenüber der Umdrucktrommel 2 und den Lichtquellen 113 auf dem Chip 112 der Belichtungsmodule 11 in Z- und Y-Richtung angeordnet ist. Die Abbildungsoptik 10 ist bezüglich ihrer Abbildungsgeometrie so beschaffen, daß die in der Belichtungszeile 114 des Belichtungsmoduls 11 erzeugten Lichtpunkte jeweils in einem Abbildungsmaßstab 1:1 auf die Umdrucktrommel 2 projiziert werden. Um eine sehr gute Abbildungsqualität der Lichtpunkte zu erreichen, müssen die eingezeichneten Abstände z4, z4′ identisch sein. Die Abbildungsoptik 10 ist dazu in einer Abdeckung 8 integriert und mit dieser über die Belichtungszeile 114 bzw. den Chips 112 mittig positioniert. Die Abdeckung 8 ihrerseits ist durch Abstandshalter 9 gegenüber den Belichtungsmodulen 11 fixiert. Darüber hinaus ist die Abdeckung 8 derart ausgestaltet, daß der Zeichengenerator 1 bis zu den Laufrollen 130 gegen äußere Verschmutzung geschützt ist, die insbesondere beim Entwickeln der latenten, elektrostatischen Bilder auf der Umdrucktrommel 2 auftritt. Die Abbildungsoptik 10 ihrerseits, die sich nach FIG 2 über die gesamte Belichtungszeile 114 des Zeichengenerators 1 erstreckt und dabei jeden Lichtpunkt der lichtemittierenden Dioden 113 im genannten Abbildungsmaßstab auf die Umdrucktrommel 2 projiziert, ist durch einen während des Abbildungsvorganges die Abbildungsoptik 10 nicht bedeckenden Verschlußmechanismus 90 gegen Verunreinigungen geschützt. Der Verschlußmechanismus 90 ist dazu auf der Abdeckung 8 in Y-Richtung verschiebbar gelagert.

## Patentansprüche

1. Anordnung zum lösbaren Befestigen von Module auf einem Modulträger, **dadurch gekennzeichnet**, daß eine Befestigungseinrichtung (7) vorgesehen ist, die gegenüber der Berührungsfläche des Moduls (11) und des Modulträgers (13) geneigt angeordnet ist und dabei das Modul (11) auf den Modulträger (13) fixiert.

2. Anordnung, nach Anspruch 1, **dadurch gekennzeichnet**, daß der Modulträger (13) eine Anlagefläche (134) senkrecht zur Berührungsfläche aufweist, an der das Modul (11) anliegt.

3. Anordnung, nach Anspruch 2, **dadurch gekennzeichnet**, daß Anlagestifte (117) im Modul (11) eingelassen sind, die im befestigten Zustand des Moduls (11) auf dem Modulträger (13) an der Anlagefläche (134) anliegen.

4. Anordnung, nach einem der Ansprüche 1 bis 3, **dadurch gekennzeichnet**, daß die Befestigungseinrichtung (7) in einer Bohrung (135) angeordnet ist, unterschiedliche Durchmesser aufweist und die zur Berührungsfläche unter einem Winkel ($\beta$) geneigt ist.

5. Anordnung, nach einem der Ansprüche 1 bis 4, **dadurch gekennzeichnet**, daß die Befestigungseinrichtung (7) eine Schraub-/Federverbindung (70, 72) enthält, die mit dem Modulträger (13) und dem Modul (11) verbunden ist.

6. Anordnung, nach einem der Ansprüche 1 bis 5, **dadurch gekennzeichnet**, daß ein oder mehrere Module (11) auf dem Modulträger (13) zwischen zwei Anschlagelementen (12) verspannt sind.

7. Anordnung, nach einem der Ansprüche 1 bis 6, **dadurch gekennzeichnet**, daß die Schraub-/Federverbindung (70, 72) eine Bewegungsschraube (72), ein Formteil (73) und eine Zugfeder (70) enthält, daß die Bewegungsschraube (72) in die Modulträgerbohrung (135) mit dem kleineren Durchmesser hineingesteckt ist, daß die Bewegungsschraube (72) in das Formteil (73) eingeschraubt ist, daß das Formteil (73) in die Zugfeder (70) eingesetzt ist und daß das Formteil (73) mit der Zugfeder in die Modulträgerbohrung (135) mit dem größeren Durchmesser hineingesteckt ist.

8. Anordnung, nach Anspruch 7, **dadurch gekennzeichnet**, daß das Formteil (73) einen zylindrischen Schaft (730) mit einem Innen- und Außengewinde und ein Ringelement (732) aufweist, das auf dem Außengewinde des zylindrischen Schafts (730) aufgeschraubt ist.

9. Anordnung, nach Anspruch 8, **dadurch gekennzeichnet**, daß das Ringelement (732) eine segmentartig ausgebildete Nase (731) aufweist, die mit dem einen Ende der Zugfeder (70) verbunden ist.

10. Anordnung, nach einem der Ansprüche 1 bis 9, **dadurch gekennzeichnet**, daß auf der Berührungsfläche des Moduls (11) ein weiteres Formteil (71) befestigt ist, das mit der Zugfeder verbunden ist.

11. Anordnung, nach einem der Ansprüche 1 bis 10, **dadurch gekennzeichnet**, daß die Bohrung (135) den Modulträger (13) durchdringt.

12. Anordnung, nach einem der Ansprüche 1 bis 6, **dadurch gekennzeichnet**, daß die Schraub-/Federverbindung (70, 72) aus einer Befestigungsschraube und einer Druckfeder aufgebaut ist.

13. Anordnung, nach einem der Ansprüche 1 bis 6, **dadurch gekennzeichnet**, daß die Bohrung (135) das modul (11) durchdringt.

14. Anordnung, nach Anspruch 13, **dadurch gekennzeichnet**, daß die Schraub-/Federverbindung (70, 72) aus einer Befestigungsschraube und einer Tellerfeder aufgebaut ist.

15. Anordnung, nach einem der Ansprüche 1 bis 14, **dadurch gekennzeichnet**, daß das Modul (11) eine Mehrzahl von Lichtquellen (113) in einer Belichtungszeile (114) aufweist, die auf einer Umdrucktrommel (2) eines nichtmechanischen Druckers ein latentes, elektrostatisches Bild erzeugen.

## Claims

1. Arrangement for detachably fastening modules to a module support, characterised in that a fastening device (7) is provided which is arranged inclined relative to the contact face of the module (11) and of the module support (13) and thus fixes the module (11) on the module support (13).

2. Arrangement according to Claim 1, characterised in that the module support (13) has an abutment face (134) perpendicular to the contact face, against which abutment face (134) the module (11) rests.

3. Arrangement according to Claim 2, characterised in that abutment pins (117) are let into the module (11), said abutment pins (117) resting against the abutment face (134) in the fastened state of the module (11) on the module support (13).

4. Arrangement according to one of Claims 1 to 3, characterised in that the fastening device (7) is arranged in a bore (135) which has different diameters and is inclined relative to the contact face at an angle (β).

5. Arrangement according to one of Claims 1 to 4, characterised in that the fastening device (7) contains a screw/spring connection (70, 72) which is connected to the module support (13) and to the module (11).

6. Arrangement according to one of Claims 1 to 5, characterised in that one or more modules (11) are clamped on the module support (13) between two stop elements (12).

7. Arrangement according to one of Claims 1 to 6, characterised in that the screw/spring connection (70, 72) contains a movement screw (72), a moulded part (73) and a tension spring (70), in that the movement screw (72) is inserted into the module support bore (135) with the smaller diameter, in that the movement screw (72) is screwed into the preformed part (73), in that the moulded part (73) is inserted into the tension spring (70), and in that the moulded part (73) is inserted, together with the tension spring, into the module support bore (135) with the larger diameter.

8. Arrangement according to Claim 7, characterised in that the moulded part (73) has a cylindrical shaft (730), with an inner thread and an outer thread, and a ring element (732) which is screwed onto the outer thread of the cylindrical shaft (730).

9. Arrangement according to Claim 8, characterised in that the ring element (732) has a nose (731) which is constructed in a segment-like manner and is connected to the one end of the tension spring (70).

10. Arrangement according to one of Claims 1 to 9, characterised in that a further moulded part (71) which is connected to the tension spring is fastened on the contact face of the module (11).

11. Arrangement according to one of Claims 1 to 10, characterised in that the bore (135) penetrates the module support (13).

12. Arrangement according to one of Claims 1 to 6, characterised in that the screw/spring connection (70, 72) is constructed from a fastening screw and a compression spring.

13. Arrangement according to one of Claims 1 to 6, characterised in that the bore (135) penetrates the module (11).

14. Arrangement according to Claim 13, characterised in that the screw/spring connection (70, 72) is constructed from a fastening screw and a cup spring.

15. Arrangement according to one of Claims 1 to 14, characterised in that the module (11) has a multiplicity of light sources (113) in an exposure line (114) which produce a latent, electrostatic image on a transfer drum (2) of a non-mechanical printer.

## Revendications

1. Dispositif pour fixer de façon amovible des modules sur un porte-modules, caractérisé par le fait qu'il est prévu un dispositif de fixation (7) qui est disposé avec inclinaison par rapport à la surface de contact du module (11) et du porte-modules (13) et fixe le module (11) sur le porte-modules (13).

2. Dispositif selon la revendication 1, caractérisé par le fait que le porte-modules (13) possède une surface d'application (134) qui est perpendiculaire à la surface de contact et contre laquelle s'applique le module (11).

3. Dispositif suivant la revendication 2, caractérisé par le fait que des broches d'application (117), qui, lorsque le module (11) est à l'état fixé, s'appliquent sur le porte-modules (13) contre la surface d'application (134), sont enchâssées dans le module (11).

4. Dispositif suivant une des revendications 1 à 3, caractérisé par le fait que le dispositif de fixation (7) est disposé dans un perçage (135), possède des diamètres différents et est incliné sous un angle (β) par rapport à la surface de contact.

5. Dispositif suivant l'une des revendications 1 à 4, caractérisé par le fait que le dispositif de fixation (7) comporte un dispositif de liaison à vis et à ressort (70,72), qui est raccordé au porte-modules (13) et au module (11).

6. Dispositif suivant l'une des revendications 1 à 5, caractérisé par le fait qu'un ou plusieurs modules (11) sont serrés sur le porte-modules (13) entre deux éléments de butée (12).

7. Dispositif suivant l'une des revendications 1 à 6, caractérisé par le fait que le dispositif de liaison à vis et à ressort (70,72) comporte une vis de déplacement (72), une pièce de forme (73) et un ressort de traction (70), que la vis de déplacement (72) est enfichée dans le perçage (135) du porte-modules, qui possède un diamètre inférieur, que la vis de déplacement (72) est vissée dans la pièce de forme (73), que la pièce de forme (73) est insérée dans le ressort de traction (70) et que la pièce de forme (73) est enfichée, avec le ressort de traction, dans le perçage (135) du porte-modules qui possède le diamètre supérieur.

8. Dispositif suivant la revendication 7, caractérisé par le fait que la pièce de forme (73) possède une tige cylindrique (103) comportant un taraudage et un filetage extérieur, et un élément annulaire (732), qui est vissé sur le filetage extérieur de la tige cylindrique (703).

9. Dispositif suivant la revendication 8, caractérisé par le fait que l'élément annulaire (732) possède un bec en forme de segment (731), qui est raccordé à une extrémité du ressort de traction (70).

10. Dispositif suivant l'une des revendications 1 à 9, caractérisé par le fait que sur la surface de contact du module (11) est fixée une autre pièce de forme (71), qui est raccordée au ressort de traction.

11. Dispositif suivant l'une des revendications 1 à 10, caractérisé par le fait que le perçage (135) traverse le porte-modules (13).

12. Dispositif suivant l'une des revendications 1 à 6, caractérisé par le fait que le dispositif de liaison à vis et à ressort (70,72) est constitué par une vis de fixation et par un ressort de pression.

13. Dispositif suivant l'une des revendications 1 à 6, caractérisé par le fait que le perçage (135) traverse le module (11).

14. Dispositif suivant la revendication 13, caractérisé par le fait que le dispositif de liaison à vis et à ressort (70, 72) est constitué par une vis de fixation et par un ressort Belleville.

15. Dispositif suivant l'une des revendications 1 à 14, caractérisé par le fait que le module (11) possède une multiplicité de sources de lumière (113) disposées suivant une ligne d'éclairement (114) et qui forment une image électrostatique latente sur un tambour de transfert (2) d'une imprimante non mécanique.

# FIG 1

# FIG 4

FIG 2

FIG 3

## FIG 5

## FIG 6

FIG 7

z
x y

β

70a

7a

136a

FIG 8

7b 136b 70b

z
x y

β

# FIG 9